# EUROPEAN PATENT APPLICATION

(11) **EP 0 683 510 A1**
(43) Date of publication of application: **22.11.1995**
(21) Application number: 95303360.2
(22) Date of filing: 19.05.1995
(51) Int. Cl.: H01L 21/3065, C23F 1/12

(54) **Method of plasma etching**

(30) Priority: 20.05.1994 JP 106447/94
(71) Applicant: HITACHI, LTD., Chiyoda-ku, Tokyo 101 (JP)
(72) Inventor: Ogawa, Yoshifumi, Hikari-shi, Yamaguchi 743 (JP); Yasunami, Hisao, Kumage-gun, Yamaguchi 742-15 (JP); Tsujimoto, Kasunori, Higashiyamato-shi, Tokyo 207 (JP); Nawata, Makoto, Yamagushi 744 (JP); Kaji, Tetsunori, Tokuyama-shi, Yamaguchi 745 (JP)
(74) Representative: Paget, Hugh Charles Edward

(57) **Abstract**

The present invention enhances silicon etching rate and improves the productivity of a silicon etching apparatus. In a vacuum chamber, plasma etching is performed. Chlorine gas is supplied at a rate of 250 ml/min or above, oxygen gas is added to the chlorine gas at 2.0% by volume or less relative to the chlorine gas. The workpiece is maintained at 0°C or below or the stage mounted with the workpiece is maintained at -10°C or below during etching.

## Description

The present invention relates to a plasma etching method for etching a workpiece, such as a silicon workpiece to form a minute pattern in the surface of the workpiece and, more particularly, to a silicon workpiece etching method capable of etching a silicon workpiece at an enhanced etching rate and effective in improving productivity.

A plasma etching method using chlorine gas to plasma-etch a workpiece, such as a silicon workpiece, for minute processing has been generally used. As is generally known, by addition of several percent oxygen to the chlorine gas, the ratio of the etching rate of an object layer to that of the underlying layer, such as a silicon dioxide film formed by thermal oxidation, (hereinafter referred to as "selectivity ratio") increases due to the difference in physical or chemical etching characteristics between the materials, which is described in, for example, J. Vac. Sci. Technol. B8(6), pp1185 to 1191, Nov/Dec 1990.

Further, a dry etching technology is described in Japanese Patent Application Laid-Open No.2-94520 (1990), wherein by using a mixture of chloride gas containing oxygen gas as an etching gas, the selectivity ratio of etching for silicon oxide is high without causing side-etching in a film excluding tungsten group films. Furthermore, a technology is described in Japanese Patent Application Laid-Open No.4-105321 (1992), wherein by heating a workpiece to a temperature above a specified value in a plasma atmosphere of a mixture of chlorine gas and oxygen gas, a multi-layered film of metallic silicon compound and poly-crystal silicon is etched to form in nearly vertical shapes without using any gases relating to fneon restriction or deposition gases.

Although the additive oxygen improves shape controllability and selectivity ratio when etching is carried out under the aforesaid conventional conditions, a large amount of protecting film is attached to the side wall and is difficult to remove, hence productivity does not increase.

It is an object of the present invention to provide a silicon etching method capable of etching a silicon or silicon compound workpiece at an increased etching rate and of improving productivity through a process having a good shape controllability with less side-wall protecting film.

Another object of the present invention is to provide a method of etching a silicon or silicon compound workpiece capable of improving the processing speed and hence improving the productivity.

A further object of the present invention is to provide a method of etching a silicon or silicon compound workpiece capable of preventing the etched workpiece from occurring notches with small amount of side-wall preventing film.

Reaction mechanism in the etched surface of a workpiece during etching under a pressure condition that can be realized by a conventional plasma etching apparatus, namely, a vacuum in the range of 0.1 to 10 Pa was examined carefully. The utility of high-speed exhaustion is described in, for example, Japanese Patent Application Laid-Open No.5-259119 (1993). According to the description about the utility of high-speed exhaustion, the silicon etching rate, when etching a polysilicon layer, can be increased by maintaining a high plasma density, maintaining a low pressure by high-speed exhaustion, and sufficiently supplying the reaction gas so that the supply of the etchant will not determine the rate of the process. In such a process, the etching rate of the underlying layer can be reduced and the selectivity ratio can be increased by maintaining ion accelerating energy on a low level.

Under such conditions including high-speed exhaustion, shape controllability (capability of obtaining a vertically worked shape (notchless) by the process which determines exactness in etching a layer in the shape of a mask, and removing side-wall protecting film) is deteriorated because the density of the reaction product decreases. Accordingly, some means for improving shape controllability is necessary. In an experimental etching operation, oxygen was added and the workpiece was cooled during etching to improve shape controllability.

It was found from the results of the experimental etching operation that, under a high-speed exhausting condition where the etching chamber is exhausted at 250 ml/min or above, etching rate is higher with less side-wall protecting film and having a good shape controllability (region capable of obtaining a vertically worked shape (notchless) and removing the side-wall protecting film), when 2.0% or less oxygen is added and the workpiece is held at a low temperature of 0°C or below, than that at which the workpiece can be etched when the workpiece is held at a room temperature. Thus, the silicon etching method of the present invention is able to secure productivity higher than that can be secured by the conventional silicon etching method.

It is known that the surface of a silicon workpiece is coated with a reaction products, such as Si-Cl and Si-Cl-O when the silicon workpiece is etched by using chlorine gas. When a resist mask, i.e., an organic film, is employed, carbon is supplied to the silicon workpiece and, consequently, Si-C having bond energy (4.64 eV) greater than that (3.99 eV and 2.75 eV) of Si-Cl and Cl-O is formed and Si-C impedes the etching of the silicon workpiece, which may be understood from a fact that the bond energy of Si-C is greater than the bond energy (3.21 eV) of Si-Si. A very small amount of oxygen is supplied from the oxide film during overetching as well as from the inner surface of the plasma etching apparatus by outgassing. Insufficient oxygen for the reaction is supplied at the former stage of the etching process because the underlying oxide film is not exposed and hence Si-C, i.e., an impediment to the silicon etching process, cannot be removed. Since the bond energy (11.1 eV) of C-O is far greater than the bond energy of Si-C, the Si and C of Si-C are separated easily and new bound molecules, such as C-O and Si-Cl, are formed, so that Si-C, i.e., an impediment to the silicon etching process, can be removed. Although the underlying oxide film is exposed partly at the latter stage of the silicon etching process, the supply of oxygen is still insufficient for the reaction when the selectivity ratio of the silicon etching process is large because the oxide film is etched scarcely by such a silicon etching process and, in some cases, the oxygen concentration cannot be increased to a value ideal for increasing the etching rate. Generally, the etching rate of a resist is two to five times that of an oxide film and is a satisfactory carbon source. Favorable effects can be exerted on selectivity ratio and etching rate by positively supplying oxygen gas into the plasma in a given oxygen concentration to cause the aforesaid change in the chemical reaction in equilibrium.

Incidentally, it often occurs in the conventional etching apparatus that the rate of process is determined by energy due to insufficient plasma density or the supply of the etchant due to insufficient exhausting performance, and the silicon etching rate cannot be increased. Therefore, the maintenance of a high-density plasma and the exhaustion of the etching chamber at a high rate will bring about characteristics different from those of the conventional etching apparatus. It is considered that etching rate could be increased by the adsorption of the etchant with less side-wall protecting film and with a good shape controllability (region capable of obtaining a vertically worked shape (notchless) and removing the side-wall protecting film) by the surface of the silicon layer of a workpiece cooled at a low temperature and the establishment of a properly equilibrated chemical reaction by the addition of oxygen. On the other hand, it is known that the reaction of a silicon dioxide film can be suppressed only when the workpiece is cooled to a very low temperature of -100°C or below. Therefore, it is considered that the cooling of the workpiece to a very low temperature is ineffective in increasing etching rate, and the chemical etching suppressing effect, i.e., effect in suppressing the recombination of Si and O, of the excessive supply of oxygen to the surface of the oxide film is dominant.

In the invention, the amount of oxygen added is preferably at least 0.3%, more preferably about 1.0%, by volume relative to the chlorine gas.

Fig. 1 is a graph showing the dependence of silicon etching rate on the flow rate of chlorine gas and the ratio of additive oxygen.

Fig. 2 is a pictorial view of assistance in explaining the effect of the ratio of additive oxygen on the shape of etched part.

Fig. 3 is a graph showing the dependence of silicon etching rate on the temperature of the workpiece.

Fig. 4 is a schematic longitudinal sectional view of an etching apparatus for carrying out the present invention.

Fig.5 is a graph showing the region for adding amount of oxygen gas to explaining the present invention.

Fig. 6 is a graph showing the relationship between etching rate and chlorine gas flow rate to explaining the present invention.

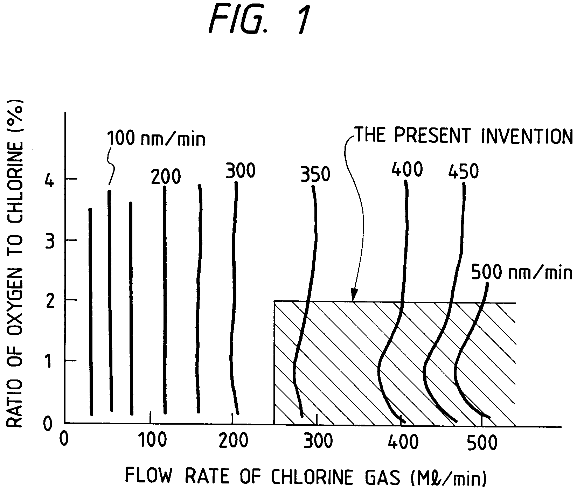

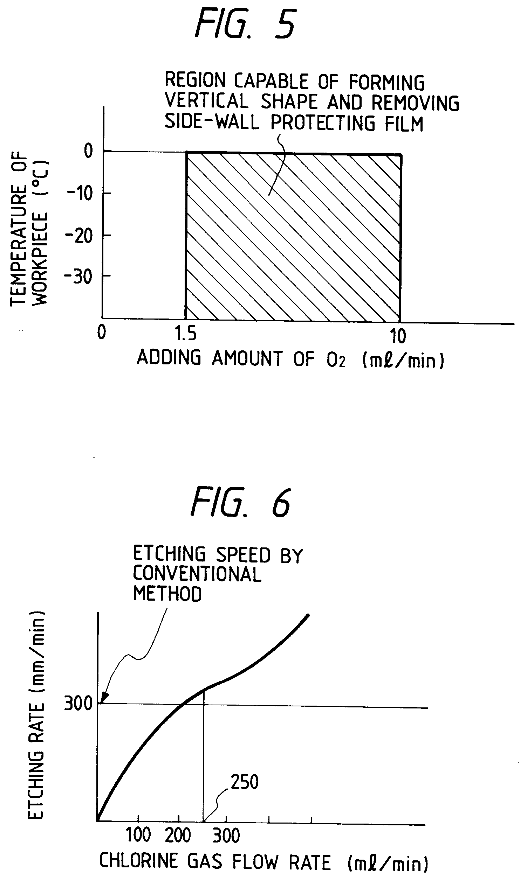

A silicon etching method in a preferred embodiment according to the present invention will be described with reference to Fig. 1, 2, 3, 5 and 6. Fig. 1 is a graph showing the dependence of silicon etching rate on the flow rate of chlorine gas and the ratio of the flow rate of oxygen gas to that of chlorine gas determined through experiments. A workpiece was maintained at -30°C by maintaining a stage mounted with the workpiece at about -50°C during etching, and the output of a power source for producing a plasma was maintained at 1 kW and the output of a bias power source for accelerating ions was maintained at 60 W to maintain a high-density plasma. Pressure of a discharge unit (upstream) relative to control pressure (downstream) were measured beforehand for each flow rate as a pressure drop, and the control pressure during etching was corrected so that the pressure in the discharge unit is 1 Pa. If the exhaustion conductance from a position where the control pressure is measured to the discharge unit in the etching chamber is sufficiently high, i.e., a condition where the pressure difference is not greater than 10% when the flow rate is 500 ml/min, such pressure correction is unnecessary. As shown in Fig. 1 and Fig. 6, the silicon etching rate is higher than the usual silicon etching rate of 300 nm/min when the flow rate is 250 ml/min or above. It is noted in Fig. 1 that the etching rate increases when the ratio of oxygen is about 1% and the etching chamber is exhausted at a high rate. When the ratio of oxygen is 2.0% or above, the silicon etching rate decreases to a value substantially equal to a silicon etching rate at which a silicon layer is etched when oxygen gas is not added to chlorine gas. When the flow rate of chlorine gas was maintained at a value of 250 ml/min or above and the ratio of oxygen was varied, the selectivity ratio remained substantially constant because silicon dioxide film etching rate increases in proportion to the increase of silicon etching rate when the ratio of oxygen was below 2.0% (preferably below 1.5%). Thus, silicon etching rate can be increased without reducing the selectivity ratio when ratio of oxygen is below 2.0% (preferably below 1.5%) and chlorine gas is supplied at 250 ml/min or above to increase the productivity.

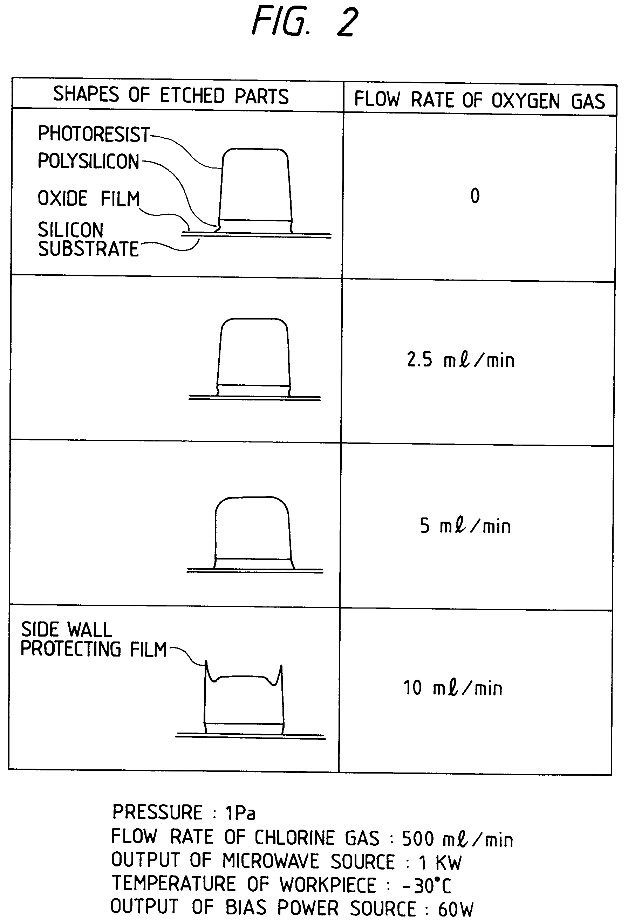

Fig. 2 shows the shapes of etched parts formed by etching in which the flow rate of chlorine gas is fixed at 500 ml/min and the ratio of oxygen was varied. As is obvious from Fig. 2, when oxygen gas is not added, notch is formed in the etched workpiece and no vertical worked shape is obtained. Further, there arises a disadvantage in that the resist on silicon is etched excessively leaving a side wall protecting film and at the same time the thickness of the side wall protecting film becomes thicker when the ratio of oxygen is 2% or above. The side wall protecting film could not be removed in a resist ashing process following the etching process when the ratio of oxygen was 2% or above. Therefore, an appropriate ratio of oxygen is below 2.0%.

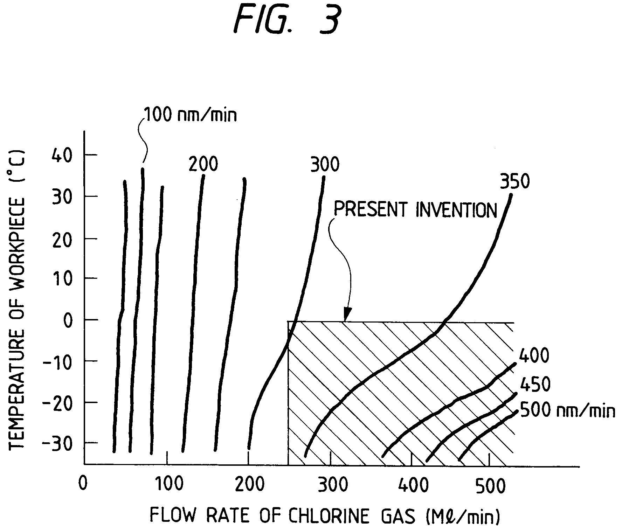

Fig. 3 shows the dependence of silicon etching rate on temperature under the high-speed exhaustion condition shown in Fig. 1 determined through experiments, in which the ratio of oxygen was fixed at 1% and the flow rate of chlorine gas was varied. It is known from Fig. 3 that silicon etching rate can be increased when the temperature of the workpiece is 0°C or below. The temperature of the workpiece was measured from behind the workpiece with a radiation thermometer. Usually, the temperature of the stage mounted with the workpiece is controlled for the indirect temperature control of the workpiece. The temperature of the stage during discharge was about -10°C. Under this condition, where the etching chamber is exhausted by high-speed exhaustion and a high-density plasma is maintained within the etching chamber, capable of etching silicon at 300 nm/min or above, it is considered that there is no large difference in input thermal energy given to the workpiece between plasma etching methods. There is a temperature difference between the stage and the workpiece during etching, and the temperature of the workpiece is greatly dependent on the mode of heat transfer from the workpiece to the stage. In the etching process in this embodiment, in which the control of the workpiece is important, it is important to enhance heat transfer from the workpiece to the stage. In this embodiment, the temperature of the stage necessary for maintaining the workpiece at 0°C was -10°C.

As is apparent from the foregoing description, etching rate can be increased without reducing the selectivity ratio by etching silicon under process conditions stated in claims, so that process time can be reduced and the productivity can be improved. Naturally, the present invention functions for the same effects when applied to etching materials containing silicon as a principal component, such as nondoped polysilicon, doped polysilicon and amorphous silicon, and silicides which are compounds of metal and silicon.

Although the data shown in Fig. 2 is obtained under a condition that the pressure in the process chamber is 1 Pa and the flow rate of chlorine gas is 500 ml/min, a preferable adding rate of oxygen when the gas pressure is changed to 0.1 to 5 Pa is determined by approximately absolute rate, but not by the ratio to the chlorine flow rate as shown in Fig. 5. Is was found that the preferable flow rate is 1.5 ml/min to 10 ml/min.

That is, as shown in Fig. 5, it has been revealed that the region in which the etched shape is a vertical shape (notchless) and the side-wall protecting film can be removed is in the range of oxygen adding amount of 1.5 ml/min to 10 ml/min for workpiece temperature of 0°C.

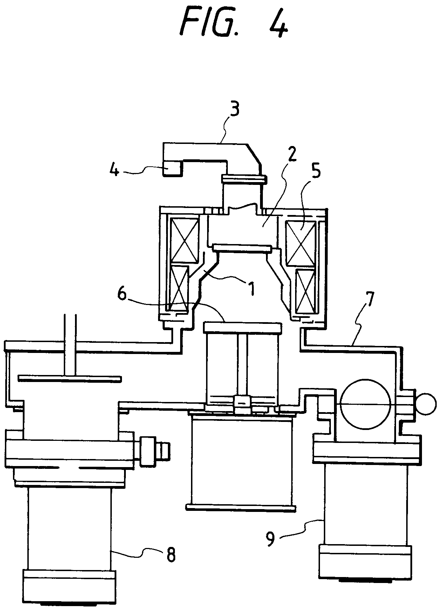

Fig. 4 shows an etching apparatus for carrying out the present invention. A stage 6 is placed within a vacuum vessel 7 a reaction chamber 1 is formed opposite to the stage 6 in the upper portion of the vacuum vessel 7. A microwave inlet window is formed above the reaction chamber 1, a cavity resonator 2 is mounted on the vacuum vessel 7, and a magnetron 4 is connected through a waveguide 3 to the cavity resonator 2. Vacuum pumps 8 and 9 are connected to the bottom of the vacuum vessel 7 respectively on the opposite sides of the stage 6. The vacuum pumps 8 and 9 have each a capacity of 2000 l/sec to evacuate the vacuum vessel 7 at a high exhaustion speed. The temperature of the stage can be controlled by a cooling system, not shown. An etching gas is supplied into the reaction chamber 1 by a processing gas supply device, not shown.

The present invention is capable of effectively etching silicon at an enhanced etching rate maintaining a high selectivity ratio and without damaging an etching resist mask with less side wall protecting film and with a good shape controllability. It is possible to prevent an etched workpiece from forming notch-shape with less side-wall protecting film. The enhanced etching rate improves the productivity of the etching apparatus.

All flow rates herein in ml/min are as measured at atmospheric pressure and at room temperature (20°C).

## Claims

1. A method of plasma etching including making a mixture of chlorine gas and oxygen gas into a plasma, and etching a specimen containing silicon using said gas, wherein the addition rate of said oxygen gas to said plasma is 1.5 to 10 ml/min and the temperature of said specimen is below 0°C.

2. A method of plasma etching according to claim 1, wherein the flow rate of said chlorine gas to said plasma is 250 ml/min or above.

3. A method of plasma etching a silicon workpiece using a plasma, comprising: supplying chlorine gas to said plasma at 250 ml/min or above; adding oxygen gas to said plasma in an amount of 2% by volume or below relative to the chlorine gas; and keeping the silicon workpiece at 0°C or below or keeping a stage mounted with the silicon workpiece at -10°C or below during etching.

4. A method of plasma etching a silicon workpiece according to claim 3, wherein the vacuum chamber is exhausted at an effective exhausting rate speed of at least 500 l/s while a plasma of density at least 5x10¹⁰cm⁻³ is maintained within the vacuum chamber.
